# EUROPEAN PATENT APPLICATION

(11) **EP 4 044 574 A1**
(43) Date of publication of application: **17.08.2022**
(21) Application number: 20874260.1
(22) Date of filing: 07.10.2020
(51) Int. Cl.: H04N 5/225, H04N 5/232, H04N 5/243, H04N 5/335

(54) **ELECTRONIC DEVICE**

(30) Priority: 07.10.2019 JP 2019184761
(71) Applicant: Sony Semiconductor Solutions Corporation, Atsugi-shi, Kanagawa 243-0014 (JP)
(72) Inventor: NAKATA, Masashi, Atsugi-shi, Kanagawa 243-0014 (JP); YAMAZAKI, Tomohiro, Atsugi-shi, Kanagawa 243-0014 (JP); KANAI, Junichi, Atsugi-shi, Kanagawa 243-0014 (JP); BABA Yuichiro, Atsugi-shi, Kanagawa 243-0014 (JP)
(74) Representative: Müller Hoffmann & Partner
(86) International application number: PCT/JP2020/038005
(87) International publication number: WO 2021/070867

(57) **Abstract**

Provided is an electronic apparatus capable of reducing a width of a bezel while reducing deterioration in image quality of an image taken by a camera.

An electronic apparatus includes a display unit, and an imaging unit disposed on a side opposite to a display surface of the display unit, in which the imaging unit has a plurality of photoelectric conversion units that photoelectrically converts light incident via the display unit, and a plurality of polarizing elements disposed on a light incident side of at least one photoelectric conversion unit of the plurality of photoelectric conversion units.

## Description

### TECHNICAL FIELD

The present disclosure relates to an electronic apparatus.

### BACKGROUND ART

In a recent electronic apparatus such as a smartphone, a mobile phone, or a personal computer (PC), a frame (bezel) of a display unit is equipped with a camera, so that video-phone call can be made or moving image can be shot easily. Because a smartphone or mobile phone is often carried in a pocket or bag, it is necessary to make an outer size thereof as compact as possible. Meanwhile, if a size of a display screen is small, the higher display resolution is, the smaller a size of displayed text is, and the more difficult to visually recognize the text. Therefore, it has been studied to reduce a width of a bezel around the display screen so that a size of the display screen is increased as much as possible without increasing an outer size of an electronic apparatus.

However, because a camera or the like is often mounted on a bezel of an electronic apparatus, a bezel width cannot be made smaller than a size of an outer diameter of the camera.

Furthermore, in a case where the camera is disposed on the bezel, for example, when a conversation is held on a video phone, a line of sight is often on around a center of the display screen, and thus, the line of sight deviates from an optical axis of the camera, and a captured image in which lines of sight do not meet is obtained, the captured image giving a feeling of uneasiness.

In order to avoid the above-described problem, it has been proposed that a camera module is disposed on a side opposite to a display surface of a display unit, and subject light having passed through the display unit is captured by a camera.

### CITATION LIST

### PATENT DOCUMENT

Patent Document 1: United States Patent Application Publication No. 2018/0069060

### SUMMARY OF THE INVENTION

### PROBLEMS TO BE SOLVED BY THE INVENTION

However, because a portion of the light passing through the display unit is reflected or diffracted and incident on the camera, there is a problem that image quality of the captured image is deteriorated being affected by flare or diffraction due to reflection.

An aspect of the present disclosure provides an electronic apparatus capable of reducing a width of a bezel while reducing deterioration in image quality of an image taken by a camera.

### SOLUTIONS TO PROBLEMS

In order to solve the above-described problem, the present disclosure provides an electronic apparatus including
a display unit, and
an imaging unit disposed on a side opposite to a display surface of the display unit,
in which the imaging unit has
a plurality of photoelectric conversion units that photoelectrically converts light incident via the display unit, and
a plurality of polarizing elements disposed on a light incident side of at least one photoelectric conversion unit of the plurality of photoelectric conversion units.

There may be included a correction unit that corrects, on the basis of polarization information polarized in the plurality of polarizing elements and photoelectrically converted in the photoelectric conversion unit, a taken image photoelectrically converted in the plurality of photoelectric conversion units.

The correction unit may remove a component obtained by at least either reflected light or diffracted light being incident on the plurality of photoelectric conversion units and imaged, the reflected light or diffracted light being generated when light passes through the display unit.

The correction unit may correct digital pixel data photoelectrically converted in the photoelectric conversion unit and digitized, by performing, on the digital pixel data, processing of subtracting a correction amount based on polarization information data obtained by digitizing the polarization information.

There may be included a polarization member that is provided on the display unit and polarizes incident light in a specific direction,
in which at least one of the plurality of polarizing elements may pass light polarized by the polarization member, and
the correction unit may correct, on the basis of the polarization information that is polarized by the polarization member, passes though the polarizing element, and is photoelectrically converted in the photoelectric conversion unit, a taken image photoelectrically converted in the plurality of photoelectric conversion units.

There may be included a light source estimation unit that estimates a type of light source of light incident on the display unit,
in which the correction unit may adjust, on the basis of a type of light source estimated in the light source estimation unit, a correction amount of a taken image photoelectrically converted in the plurality of photoelectric conversion units.

There may be included a luminance estimation unit that estimates display luminance of the display unit,
in which the correction unit may adjust, according to display luminance of the display unit, a correction amount of a taken image photoelectrically converted in the plurality of photoelectric conversion units.

There may be included a signal processing unit that performs at least one of exposure processing, focus adjustment processing, or white balance adjustment processing on a taken image corrected in the correction unit.

There may be included a signal processing unit that performs at least one type of signal processing on a taken image corrected in the correction unit, and
a parameter adjustment unit that adjusts a parameter for when performing signal processing on the taken image according to a correction amount by which the correction unit corrects the taken image.

Signal processing performed by the signal processing unit may include at least either noise reduction processing that removes a noise component included in the taken image, or edge enhancement processing that enhances an edge in the taken image, and
the parameter adjustment unit may adjust, according to the correction amount, a parameter for when performing at least either the noise reduction processing or the edge enhancement processing.

The parameter adjustment unit may perform, for a taken image having a larger correction amount, at least either processing of further increasing a degree of noise removal in the noise reduction processing, or processing of further increasing a degree of edge enhancement in the edge enhancement processing.

The signal processing unit may perform signal processing including exposure adjustment processing, and, when performing the exposure adjustment processing, perform exposure adjustment so that output values of the plurality of photoelectric conversion units do not saturate.

There may be included a defect correction unit that corrects, by using output values of surrounding two or more of the photoelectric conversion units, an output value of the photoelectric conversion unit on which light polarized by the polarizing element is incident.

There may be included an imaging device having the photoelectric conversion unit and an optical system that condenses light on the photoelectric conversion unit,
in which the imaging device may be disposed on a side opposite to a vicinity of a substantially central portion of a display surface of the display unit.

There may be included a defect correction unit that corrects an output value of a photoelectric conversion unit of which output value saturates, for a photoelectric conversion unit of which output value saturates among the plurality of photoelectric conversion units, on the basis of polarization information that is polarized in one or more of the polarizing elements disposed around the photoelectric conversion unit, and is photoelectrically converted in the photoelectric conversion unit.

The photoelectric conversion unit may have a plurality of divided photoelectric conversion units, and
light polarized by the plurality of polarizing elements may be incident on the plurality of divided photoelectric conversion units in some of the photoelectric conversion units.

The photoelectric conversion unit may have a plurality of divided photoelectric conversion units, and
light polarized by the polarizing element may be incident on some of the divided photoelectric conversion units in any of the photoelectric conversion units.

The photoelectric conversion unit may have a plurality of divided photoelectric conversion units, and
light polarized by the polarizing element may be incident on the divided photoelectric conversion unit for each unit of two or more of the photoelectric conversion units.

The plurality of photoelectric conversion units may have a plurality of divided photoelectric conversion units, and light polarized by the plurality of polarizing elements may be incident on the plurality of photoelectric conversion units.

The photoelectric conversion unit may have a plurality of divided photoelectric conversion units divided into two or more in one direction and capable of detecting phase difference information, and
light polarized by the polarizing element may be incident on the plurality of divided photoelectric conversion units in any of the photoelectric conversion units.

### BRIEF DESCRIPTION OF DRAWINGS

Fig. 1 is a schematic cross-sectional view of an electronic apparatus according to a first embodiment.
Fig. 2(a) is a schematic external view of the electronic apparatus in Fig. 1, and Fig. 2(b) is a cross-sectional view taken along a line A-A in Fig. 2(a).
Fig. 3 is a plan view illustrating an example of a pixel array of a plurality of polarization pixels and a plurality of non-polarization pixels.
Fig. 4A is a diagram illustrating a detailed cross-sectional structure of an imaging unit according to the present embodiment.
Fig. 4B is a cross-sectional view in a case where a plurality of polarization pixels is disposed on an on-chip lens.
Fig. 5 is a perspective view illustrating an example of a detailed structure of each polarization pixel.
Fig. 6A is a diagram schematically illustrating a state in which flare occurs when an image of a subject is captured by the electronic apparatus in Fig. 1.
Fig. 6B is a diagram illustrating a signal component included in the taken image in Fig. 6A.
Fig. 7A is a diagram conceptually describing correction processing according to the present embodiment.
Fig. 7B is a diagram conceptually describing correction processing according to the present embodiment.
Fig. 7C is a diagram conceptually describing correction processing according to the present embodiment.
Fig. 8 is a block diagram illustrating an internal configuration of the electronic apparatus according to the present embodiment.
Fig. 9 is a flowchart illustrating a processing procedure of image capturing processing performed by the electronic apparatus according to the present embodiment.
Fig. 10 is a flowchart illustrating a processing procedure of image capturing processing performed by the electronic apparatus according to the present embodiment.
Fig. 11 is a plan view illustrating an example of a pixel array of a plurality of polarization pixels and a plurality of non-polarization pixels according to a third embodiment.
Fig. 12 is a plan view illustrating a first modification of a divided structure.
Fig. 13 is a plan view illustrating a second modification of the divided structure.
Fig. 14 is a plan view illustrating a third modification of the divided structure.
Fig. 15 is a plan view illustrating a fourth modification of the divided structure.
Fig. 16 is a schematic cross-sectional view of an electronic apparatus according to a fourth embodiment.
Fig. 17 is a cross-sectional view of a first modification in which a structure of a display unit 2 is characterized.
Fig. 18 is a cross-sectional view of the second modification in which a structure of the display unit 2 is characterized.
Fig. 19 is a plan view in a case where the electronic apparatus according to the first to fourth embodiments is applied to a capsule endoscope.
Fig. 20 is a rear view in a case where an electronic apparatus according to the first to fourth embodiments is applied to a digital single-lens reflex camera.
Fig. 21A is a diagram illustrating an example in which an electronic apparatus 1 is applied to an HMD.
Fig. 21B is a diagram illustrating a current HMD.
Fig. 22 is a block diagram illustrating a schematic configuration of an electronic apparatus according to a sixth embodiment.
Fig. 23 is a block diagram illustrating a schematic configuration of an electronic apparatus according to a modification of the sixth embodiment.
Fig. 24 is a diagram illustrating a cross-sectional structure of an imaging unit of a camera module mounted on an electronic apparatus according to a seventh embodiment.

### MODE FOR CARRYING OUT THE INVENTION

Hereinafter, embodiments of an electronic apparatus will be described with reference to the drawings. Although main components of the electronic apparatus will be mainly described below, the electronic apparatus may have a component or function that is not illustrated or described. The following description does not exclude the component or function that is not illustrated or described.

### (First embodiment)

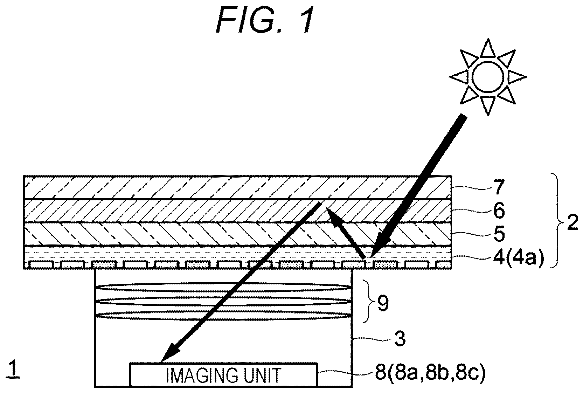

Fig. 1 is a schematic cross-sectional view of an electronic apparatus 1 according to a first embodiment. The electronic apparatus 1 in Fig. 1 is an arbitrary electronic apparatus, such as a smartphone, a mobile phone, a tablet terminal, or a PC, having both a display function and an image capturing function. The electronic apparatus 1 in Fig. 1 includes a camera module (imaging unit) disposed on a side opposite to a display surface of a display unit 2. Thus, the electronic apparatus 1 in Fig. 1 is provided with a camera module 3 on a back side of the display surface of the display unit 2. Therefore, the camera module 3 captures an image through the display unit 2.

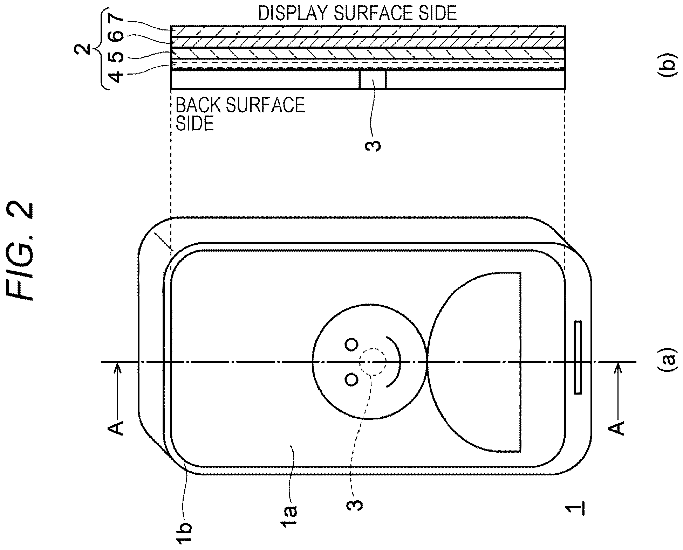

Fig. 2(a) is a schematic external view of the electronic apparatus 1 in Fig. 1, and Fig. 2(b) is a cross-sectional view taken along a line A-A in Fig. 2(a). In the example in Fig. 2(a), the display screen 1a spreads close to an outer size of the electronic apparatus 1, and a width of a bezel 1b around the display screen 1a is a few mm or less. Normally, a front camera is often mounted on the bezel 1b, whereas in Fig. 2(a), as indicated by a broken line, the camera module 3 that functions as a front camera is disposed on a back surface side of a substantially central portion of the display screen 1a. Thus, by providing the front camera on the back surface side of the display screen 1a, it is not necessary to dispose the front camera on the bezel 1b, and the width of the bezel 1b can be narrowed.

Note that, although the camera module 3 is disposed on the back surface side of the substantially central portion of the display screen 1a in Fig. 2(a), in the present embodiment, it is sufficient if the camera module 3 is disposed on the back surface side of the display screen 1a, and for example, the camera module 3 may be disposed near a peripheral edge on the back surface side of the display screen 1a. Thus, the camera module 3 in the present embodiment is disposed at an arbitrary position on the back surface side, the arbitrary portion overlapping the display screen 1a.

As illustrated in Fig. 1, the display unit 2 is a structure in which a display panel 4, a circularly polarizing plate 5, a touch panel 6, and a cover glass 7 are laminated in this order. The display panel 4 may be, for example, an organic light emitting device (OLED) unit, a liquid crystal display unit, a micro LED, or the display unit 2 based on another display principle. The display panel 4 such as the OLED unit includes a plurality of layers. The display panel 4 is often provided with a member having low transmittance such as a color filter layer. As described later, a through hole may be formed in a member having a low transmittance in the display panel 4 in accordance with a location where the camera module 3 is disposed. If the through hole is such that subject light passing through the through hole is incident on the camera module 3, image quality of an image captured by the camera module 3 can be improved.

The circularly polarizing plate 5 is provided to reduce glare and enhance visibility of the display screen 1a even in a bright environment. A touch sensor is incorporated in the touch panel 6. There are various kinds of touch sensors such as a capacitive type or a resistive film type, and any type may be used. Furthermore, the touch panel 6 and the display panel 4 may be integrated. The cover glass 7 is provided to protect the display panel 4 and the like.

The camera module 3 has an imaging unit 8 and an optical system 9. The optical system 9 is disposed on a light incident surface side of the imaging unit 8, that is, on a side close to the display unit 2, and condenses light on the imaging unit 8, the light passing through the display unit 2. The optical system 9 normally includes a plurality of lenses.

The imaging unit 8 has a plurality of photoelectric conversion units 8a and a plurality of polarizing elements 8b. A photoelectric conversion unit 8a photoelectrically converts light incident via the display unit 2. The photoelectric conversion unit 8a may be a complementary metal oxide semiconductor (CMOS) sensor or a charge coupled device (CCD) sensor. Furthermore, the photoelectric conversion unit 8a may be a photodiode or an organic photoelectric conversion film. The plurality of photoelectric conversion units 8a can be arrayed in an arbitrary manner. An array system of the plurality of photoelectric conversion units 8a may be a Bayer array, an interline array, a checkered array, a stripe array, or another array.

A plurality of polarizing elements 8b is disposed on a light incident side of at least one photoelectric conversion unit 8a among the plurality of photoelectric conversion units 8a. A polarizing element 8b polarizes incident light that passes through the display unit 2. The light polarized by the polarizing element 8b is incident on a corresponding photoelectric conversion unit 8a and is photoelectrically converted. In the present specification, an output value of a photoelectric conversion unit 8a that photoelectrically converts light polarized by a polarizing element 8b is referred to as polarization information, and an output value of a photoelectric conversion unit 8a that photoelectrically converts light incident without passing through a polarizing element 8b is referred to as a pixel value or pixel information. Furthermore, in the present specification, a combination of a polarizing element 8b and a photoelectric conversion unit 8a that photoelectrically converts light polarized by the polarizing element 8b is referred to as a polarization pixel, and a photoelectric conversion unit 8a that photoelectrically converts light incident without passing through the polarizing element 8b is referred to as a non-polarization pixel.

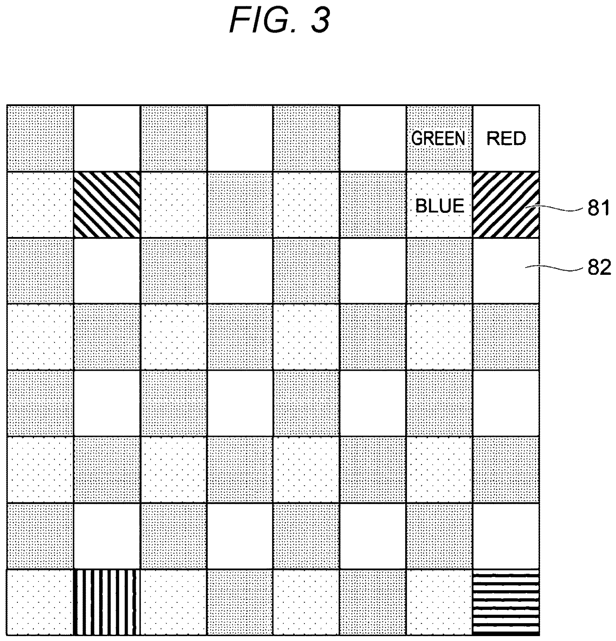

Fig. 3 is a plan view illustrating an example of a pixel array of a plurality of polarization pixels 81 and a plurality of non-polarization pixels 82. In the example in Fig. 3, the plurality of non-polarization pixels 82 for three RGB colors is disposed in two-dimensional directions, and the plurality of polarization pixels 81 is disposed separately from one another between the plurality of non-polarization pixels 82.

Fig. 3 is a plan view of the plurality of non-polarization pixels 82 and the plurality of polarization pixels 81 viewed from the light incident side. Although one each of four types of polarization pixels 81 having different polarization directions are disposed in an area where 8 × 8 = 64 non-polarization pixels 82 are disposed in the example in Fig. 3, a ratio of the number of polarization pixels 81 to the number of non-polarization pixels 82, types of the polarization pixels 81, and locations where the polarization pixels 81 are disposed are arbitrary.

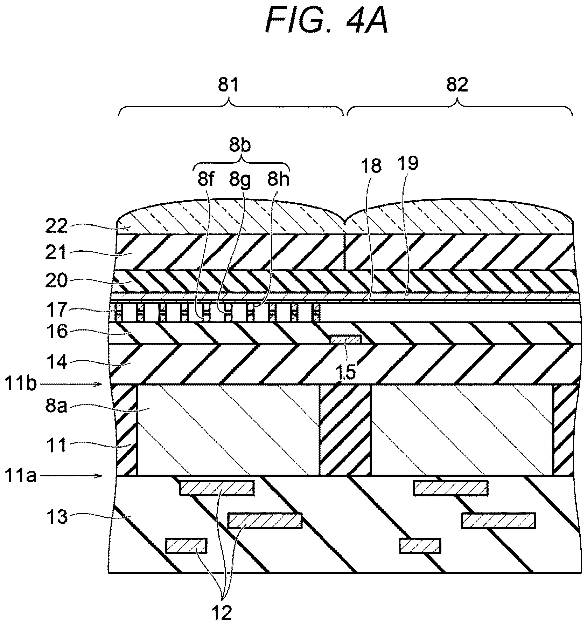

Fig. 4A is a diagram illustrating a detailed cross-sectional structure of the imaging unit 8 according to the present embodiment. As illustrated in Fig. 4A, a plurality of photoelectric conversion units 8a is disposed in a substrate 11. A plurality of wiring layers 12 is disposed on a side close to a first surface 11a of the substrate 11. An interlayer insulation film 13 is disposed around the plurality of wiring layers 12. Although unillustrated contacts that connect these wiring layers 12, or connect a wiring layer 12 and a photoelectric conversion unit 8a are provided, the contacts are omitted in Fig. 4A.

On a side close to a second surface 11b of the substrate 11, via a planarization layer 14, a light-shielding layer 15 is disposed in a vicinity of a boundary of a pixel, and a base insulation layer 16 is disposed around the light-shielding layer 15. On the base insulation layer 16, a plurality of polarizing elements 8b is disposed separately from one another. Each of the polarizing elements 8b in Fig. 4A is a wire grid polarizing element that has a line-and-space structure and is disposed in a part of an insulation layer 17.

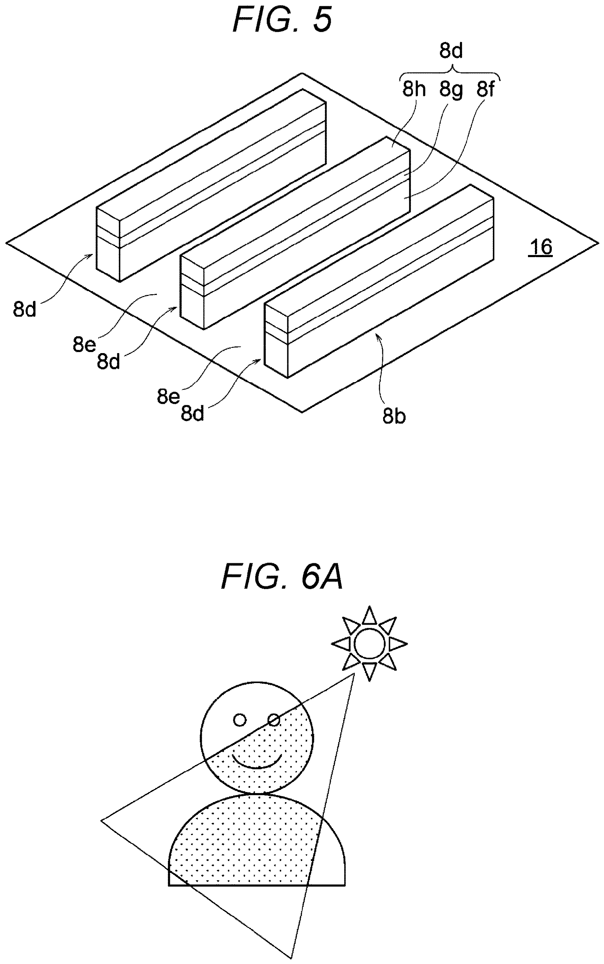

Fig. 5 is a perspective view illustrating an example of a detailed structure of each of the polarizing elements 8b. As illustrated in Fig. 5, each of the plurality of polarizing elements 8b has a plurality of line parts 8d having a protruding shape and extending in one direction, and a space part 8e between the respective line parts 8d. There is a plurality of types of polarizing elements 8b with different extending directions of the line parts 8d. More specifically, there may be three or more types of polarizing elements 8b, and for example, an angle formed by a direction in which a photoelectric conversion unit 8a is arrayed and a direction in which the line parts 8d extend may be three types of 0 degrees, 60 degrees, and 120 degrees. Alternatively, an angle formed by a direction in which a photoelectric conversion unit 8a is arrayed and a direction in which the line parts 8d extend may be four types of 0 degrees, 45 degrees, 90 degrees, and 135 degrees, or may be other angles. Alternatively, the plurality of polarizing elements 8b may polarize only in a single direction. A material of the plurality of polarizing elements 8b may be a metal material such as aluminum or tungsten, or an organic photoelectric conversion film.

Thus, each of the polarizing elements 8b has a structure in which a plurality of line parts 8d extending in one direction is disposed separately from one another in a direction intersecting the one direction. There is a plurality of types of polarizing elements 8b with different extending directions of the line parts 8d. These polarizing elements 8b are disposed separately from one another so as to overlap with a part of a two-dimensional array of the plurality of photoelectric conversion units 8a.

A line part 8d has a laminated structure in which a light reflection layer 8f, an insulation layer 8g, and a light absorption layer 8h are laminated. The light reflection layer 8f includes, for example, a metal material such as aluminum. The insulation layer 8g includes, for example, SiO2 or the like. The light absorption layer 8h is, for example, a metal material such as tungsten.

Returning to Fig. 4A, on the insulation layer 17 in which the plurality of polarizing elements 8b is disposed, a planarization layer 20 is disposed via protection layers 18 and 19. A color filter layer 21 is disposed on the planarization layer 20. The color filter layer 21 may have filter layers of the three RGB colors, or may have filter layers of cyan, magenta, and yellow that are complementary colors of the three RGB colors. Alternatively, a filter layer that transmits color other than visible light such as infrared light may be included, a filter layer having a multispectral characteristic may be included, or a filter layer of subtractive color, such as white, may be included. By transmitting light other than visible light such as infrared light, sensing information such as depth information can be detected. An on-chip lens 22 is disposed on the color filter layer 21.

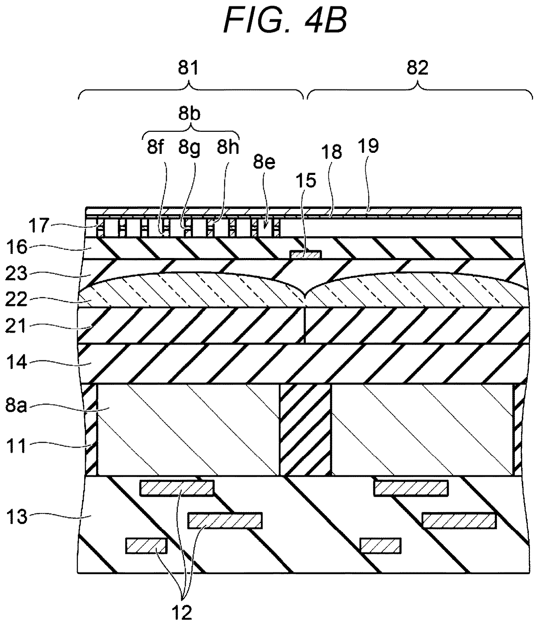

Although the on-chip lens 22 is disposed above the plurality of polarizing elements 8b in the cross-sectional structure in Fig. 4A, as illustrated in Fig. 4B, the plurality of polarizing elements 8b may be disposed above the on-chip lens 22. The cross-sectional structure in Fig. 4B is similar to the cross-sectional structure in Fig. 4A except that the on-chip lens 22 and the plurality of polarizing elements 8b are laminated in a different order.

Furthermore, a layer configuration of a part of the cross-sectional structures in Figs. 4A and 4B may be arbitrarily changed. For example, in Fig. 4A, the insulation layer 16 on which the plurality of polarizing elements 8b is disposed, and the color filter layer 21 may be integrated into one layer.

Next, characteristic operation of the electronic apparatus 1 according to the present embodiment will be described. Fig. 6A is a diagram schematically illustrating a state in which flare occurs when an image of a subject is captured by the electronic apparatus 1 in Fig. 1. The flare occurs when a portion of light incident on the display unit 2 of the electronic apparatus 1 is repeatedly reflected by any of members in the display unit 2, and then is incident on the imaging unit 8 and captured in a taken image. If the flare occurs in the taken image, a luminance difference or a change in hue occurs as illustrated in Fig. 6A, and image quality is deteriorated.

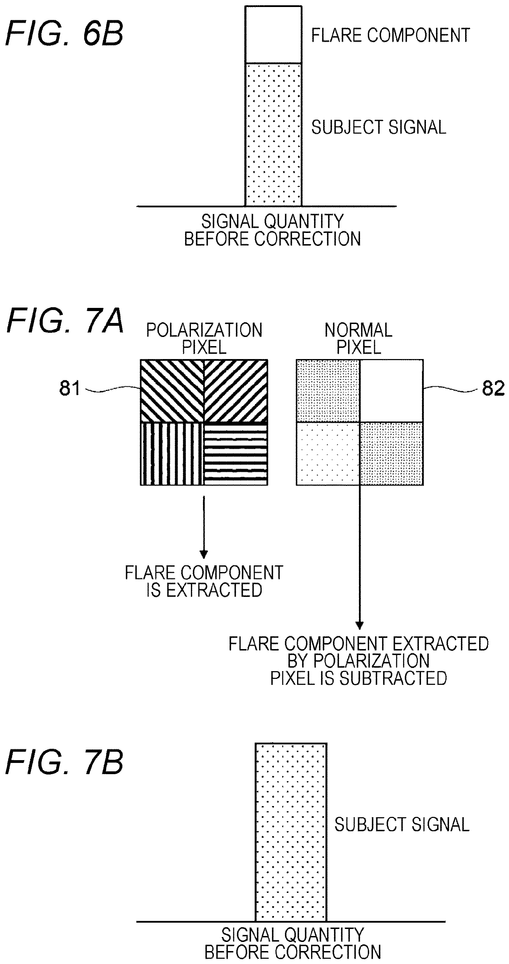

Fig. 6B is a diagram illustrating a signal component included in the taken image in Fig. 6A. As illustrated in Fig. 6B, a captured image includes a subject signal and a flare component.

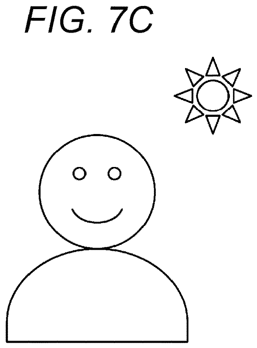

Figs. 7A, 7B, and 7C are diagrams conceptually describing correction processing according to the present embodiment. As illustrated in Fig. 7A, the imaging unit 8 according to the present embodiment has a plurality of polarization pixels 81 and a plurality of non-polarization pixels 82. Pixel information photoelectrically converted by the plurality of non-polarization pixels 82 illustrated in Fig. 7A includes a subject signal and a flare component as illustrated in Fig. 6B. Meanwhile, polarization information photoelectrically converted by the plurality of polarization pixels 81 illustrated in Fig. 7A is flare component information. Therefore, by subtracting the polarization information photoelectrically converted by the plurality of non-polarization pixels 82 from the pixel information photoelectrically converted by the plurality of polarization pixels 81, as illustrated in Fig. 7B, the flare component is removed and the subject signal is obtained. If an image based on the subject signal is displayed on the display unit 2, as illustrated in Fig. 7C, a subject image from which the flare existing in Fig. 6A has been removed is displayed.

Although an example in which a subject image is affected by flare has been described in Figs. 6A to 6B and Figs. 7A to 7C, there may be a case where external light incident on the display unit 2 is diffracted by a wiring pattern or the like in the display unit 2, and the diffracted light may be incident on the imaging unit 8. Thus, at least either the flare or the diffracted light may be captured in the taken image.

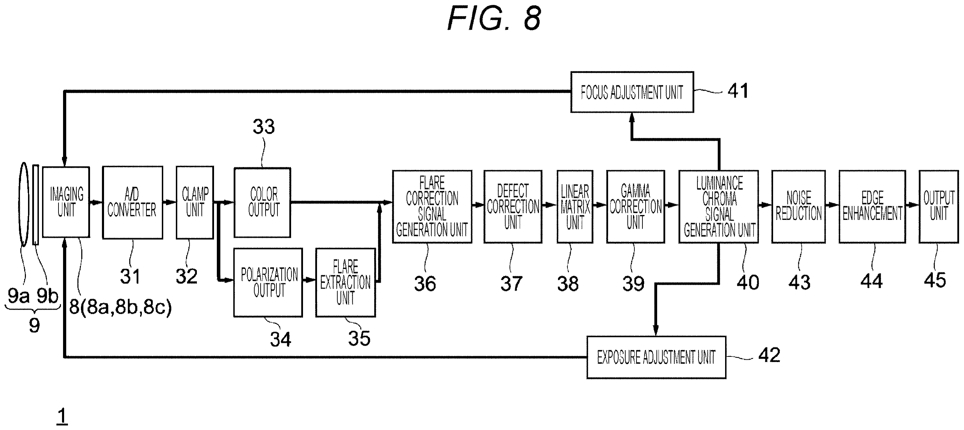

Fig. 8 is a block diagram illustrating an internal configuration of the electronic apparatus 1 according to the present embodiment. The electronic apparatus 1 in Fig. 8 includes the optical system 9, the imaging unit 8, an A/D converter 31, a clamp unit 32, a color output unit 33, a polarization output unit 34, a flare extraction unit 35, a flare correction signal generation unit 36, a defect correction unit 37, a linear matrix unit 38, a gamma correction unit 39, a luminance chroma signal generation unit 40, a focus adjustment unit 41, an exposure adjustment unit 42, a noise reduction unit 43, an edge enhancement unit 44, and an output unit 45.

The optical system 9 has one or more lenses 9a and an infrared ray (IR) cut filter 9b. The IR cut filter 9b may be omitted. As described above, the imaging unit 8 has the photoelectric conversion unit 8a having the plurality of non-polarization pixels 82 and the plurality of polarization pixels 81.

Output values of the plurality of polarization pixels 81 and output values of the plurality of non-polarization pixels 82 are input to the A/D converter 31. The A/D converter 31 outputs polarization information data obtained by digitizing the output values of the plurality of polarization pixels 81 and digital pixel data obtained by digitizing the output values of the plurality of non-polarization pixels 82.

The clamp unit 32 performs processing of defining a black level, and subtracts black level data from each of the digital pixel data and the polarization information data. Output data from the clamp unit 32 is branched, and thus RGB digital pixel data is output from the color output unit 33, and polarization information data is output from the polarization output unit 34. The flare extraction unit 35 extracts at least either a flare component or a diffracted light component from the polarization information data. In the present specification, at least either the flare component or diffracted light component extracted by the flare extraction unit 35 may be referred to as a correction amount.

The flare correction signal generation unit 36 corrects the digital pixel data output from the color output unit 33 by performing, on the digital pixel data, processing of subtracting a correction amount extracted in the flare extraction unit 35. The output data from the flare correction signal generation unit 36 is digital pixel data from which at least either the flare component or the diffracted light component has been removed. Thus, the flare correction signal generation unit 36 functions as a correction unit that corrects, on the basis of the polarization information, the taken image photoelectrically converted by the plurality of non-polarization pixels 82.

The digital pixel data at a pixel position of the polarization pixel 81 has a lower signal level by an amount passing through the polarizing element 8b. Therefore, the defect correction unit 37 regards the polarization pixel 81 as a defect and performs predetermined defect correction processing. The defect correction processing in this case may be processing of interpolation by using digital pixel data of surrounding pixel positions.

The linear matrix unit 38 performs matrix operation on color information such as RGB to perform more correct color reproduction. The linear matrix unit 38 is also referred to as a color matrix unit.

The gamma correction unit 39 performs gamma correction so as to enable display with excellent visibility in accordance with a display characteristic of the display unit 2. For example, the gamma correction unit 39 converts 10 bits into 8 bits while changing a gradient.

The luminance chroma signal generation unit 40 generates, on the basis of the output data from the gamma correction unit 39, a luminance chroma signal to be displayed on the display unit 2.

The focus adjustment unit 41 performs autofocus processing on the basis of a luminance chroma signal having been subjected to the defect correction processing. The exposure adjustment unit 42 performs exposure adjustment on the basis of the luminance chroma signal having been subjected to the defect correction processing. When the exposure adjustment is performed, the exposure adjustment may be performed by providing an upper limit clip so that a pixel value of each of the non-polarization pixels 82 does not saturate. Furthermore, in a case where the pixel value of each of the non-polarization pixels 82 saturates even if the exposure adjustment is performed, the pixel value of the saturated non-polarization pixel 82 may be estimated on the basis of a pixel value of a polarization pixel 81 around the non-polarization pixel 82.

The noise reduction unit 43 performs processing of reducing noise included in the luminance chroma signal. The edge enhancement unit 44 performs processing of enhancing an edge in the subject image on the basis of the luminance chroma signal. Noise reduction processing by the noise reduction unit 43 and edge enhancement processing by the edge enhancement unit 44 may be performed only in a case where a predetermined condition is satisfied. The predetermined condition is, for example, a case where a correction amount of the flare component or diffracted light component extracted by the flare extraction unit 35 exceeds a predetermined threshold value. The more a flare component or diffracted light component included in a taken image, the more noise or blurring of the edge occurs in an image from which the flare component or the diffracted light component is removed. Therefore, by performing the noise reduction processing or the edge enhancement processing only in a case where the correction amount exceeds the threshold value, frequency of performing the noise reduction processing or the edge enhancement processing can be reduced.

Signal processing by at least some of the defect correction unit 37, the linear matrix unit 38, the gamma correction unit 39, the luminance chroma signal generation unit 40, the focus adjustment unit 41, the exposure adjustment unit 42, the noise reduction unit 43, and the edge enhancement unit 44 in Fig. 8 may be executed by a logic circuit in an image sensor having the imaging unit 8, or may be executed by a signal processing circuit in the electronic apparatus 1 equipped with the image sensor. Alternatively, signal processing of at least a part of Fig. 8 may be executed by a server or the like on a cloud, the server or the like transmitting and receiving information to and from the electronic apparatus 1 via a network. As illustrated in the block diagram in Fig. 8, in the electronic apparatus 1 according to the present embodiment, the flare correction signal generation unit 36 performs various kinds of signal processing on the digital pixel data from which at least either the flare component or the diffracted light component has been removed. In particular, this is because, in some signal processing such as exposure processing, focus adjustment processing, and white balance adjustment processing, a favorable signal processing result cannot be obtained even if the signal processing is performed in a state where a flare component or a diffracted light component is included.

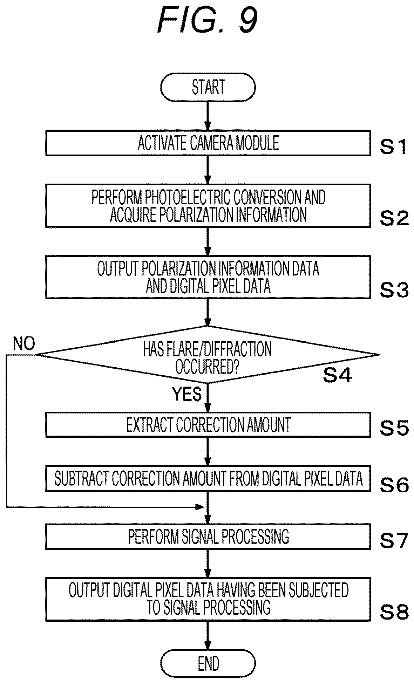

Fig. 9 is a flowchart illustrating a processing procedure of image capturing processing performed by the electronic apparatus 1 according to the present embodiment. First, the camera module 3 is activated (step S1). With this arrangement, power supply voltage is supplied to the imaging unit 8, and the imaging unit 8 starts imaging incident light. More specifically, the plurality of non-polarization pixels 82 photoelectrically converts the incident light, and the plurality of polarization pixels 81 acquires polarization information of the incident light (step S2). The A/D converter 31 outputs polarization information data obtained by digitizing the output values of the plurality of polarization pixels 81 and digital pixel data obtained by digitizing the output values of the plurality of non-polarization pixels 82 (step S3).

Next, on the basis of the polarization information data, the flare extraction unit 35 determines whether or not flare or diffraction has occurred (step S4). Here, for example, if the polarization information data exceeds a predetermined threshold value, it is determined that flare or diffraction has occurred. If it is determined that flare or diffraction has occurred, the flare extraction unit 35 extracts a correction amount of the flare component or diffracted light component on the basis of the polarization information data (step S5). The flare correction signal generation unit 36 subtracts the correction amount from the digital pixel data to generate digital pixel data from which the flare component or the diffracted light component has been removed (step S6).

Next, various kinds of signal processing are performed on the digital pixel data corrected in step S6 or the digital pixel data for which, in step S4, it is determined that flare or diffraction has not occurred (step S7). More specifically, in step S7, as illustrated in Fig. 8, processing such as defect correction processing, linear matrix processing, gamma correction processing, luminance chroma signal generation processing, exposure processing, focus adjustment processing, white balance adjustment processing, noise reduction processing, or edge enhancement processing is performed. Note that a type and execution order of the signal processing are arbitrary, and signal processing of some blocks illustrated in Fig. 8 may be omitted, or signal processing other than the blocks illustrated in Fig. 8 may be performed.

The digital pixel data having been subjected to the signal processing in step S7 may be output from the output unit 45 and stored in an unillustrated memory, or may be displayed on the display unit 2 as a live image (step S8).

Thus, in the first embodiment, the camera module 3 is disposed on the side opposite to the display surface of the display unit 2, and polarization information of light passing through the display unit 2 is acquired by the plurality of polarization pixels 81. A portion of the light passing through the display unit 2 is repeatedly reflected in the display unit 2, and then is incident on the plurality of non-polarization pixels 82 in the camera module 3. According to the present embodiment, by acquiring the above-described polarization information, it is possible to generate a taken image in a state where a flare component or diffracted light component included in light incident on the plurality of non-polarization pixels 82 after being repeatedly reflected in the display unit 2 is simply and reliably removed. More specifically, in the present embodiment, digital pixel data from which a flare component or a diffracted light component has been removed can be generated by performing, on digital pixel data imaged and A/D-converted by the plurality of non-polarization pixels 82 that photoelectrically converts light incident without passing through a polarizing element 8b, processing of subtracting a correction amount based on polarization information acquired by the plurality of polarization pixels 81.

### (Second embodiment)

Although, in the flare correction signal generation unit 36 in Fig. 8, processing of subtracting a correction amount based on polarization information acquired by the plurality of polarization pixels 81 is performed on digital pixel data imaged by the plurality of non-polarization pixels 82, an S/N ratio of the digital pixel data having been subjected to the subtraction may be deteriorated due to the subtraction processing. This is because light shot noise superimposed on a flare component cannot be removed by the subtraction processing described above.

Therefore, a degree of noise removal in the noise reduction processing may be adjusted according to a magnitude of the correction amount by the flare component or the diffracted light component. More specifically, the larger the correction amount, the higher the degree of noise removal in the noise reduction processing. Furthermore, in a case where an edge becomes unclear by further increasing the degree of noise removal in the noise reduction processing, a degree of edge enhancement in the edge enhancement processing may be further increased.

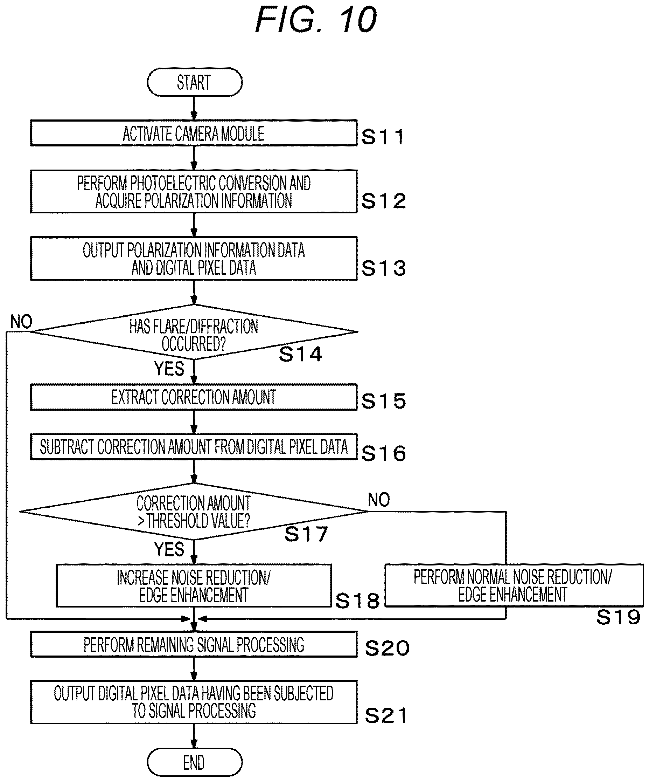

Fig. 10 is a flowchart illustrating a processing procedure of image capturing processing performed by an electronic apparatus 1 according to the present embodiment. Because the processing from steps S11 to S16 is similar to steps S1 to S6 in Fig. 9, the description thereof will be omitted. After the processing of subtracting the correction amount from the digital pixel data ends in step S16, next, it is determined whether or not the correction amount extracted in step S14 exceeds a predetermined threshold value (step S17). If it is determined that the correction amount exceeds the threshold value, at least either the degree of noise removal in the noise reduction processing or the degree of edge enhancement in the edge enhancement processing is further increased (step S18). That is, in a case where the correction amount of the flare component or diffracted light component is large, processing of further increasing the degree of noise removal or of further enhancing the edge is performed. With this arrangement, even if the S/N ratio decreases by subtracting the correction amount from the digital pixel data, it is possible to reduce the decrease in the S/N ratio by appropriately performing the noise removal processing or the edge enhancement processing.

Meanwhile, if it is determined that the correction amount does not exceed the threshold value, normal noise reduction processing and edge enhancement processing are performed (step S19) .

In a case where it is determined in step S14 that no flare or diffraction has occurred, or in a case where the processing in step S18 has ended, or in a case where the processing in step S19 has ended, other signal processing is performed (step S20). When all the signal processing is completed, digital pixel data is output (step S21).

Although Fig. 10 illustrates an example in which a degree of noise reduction processing or edge enhancement processing is increased in a case where a correction amount exceeds a threshold value, for arbitrary signal processing other than the processing, specific content of the signal processing may be switched depending on whether or not the correction amount exceeds the threshold value. In this case, there may be provided a parameter adjustment unit that adjusts a parameter for when performing arbitrary signal processing according to the correction amount. Because it is conceivable that an amount of adjusting the parameter varies depending on content of the signal processing, the parameter adjustment unit may set, according to the correction amount, an optimum parameter for each unit that performs each signal processing. Note that, in the above-described example, the noise reduction unit 43 and the edge enhancement unit 44 also serve as the parameter adjustment unit. The noise reduction unit 43 adjusts a parameter for deciding a degree of noise removal, and the edge enhancement unit 44 adjusts a parameter for deciding a degree of edge enhancement.

Furthermore, although, in steps S17 to S19 in Fig. 10, a degree of the noise reduction processing or edge enhancement processing is switched in two ways depending on whether or not the correction amount exceeds the threshold value, the degree of the noise reduction processing or edge enhancement processing may be switched in finer three or more stages according to the correction amount of the flare component or diffracted light component, a state of the subject, or the like.

Thus, in the second embodiment, in a case where an S/N ratio of the digital pixel data having been subjected to the subtraction may decrease by subtracting the correction amount based on the flare component or the diffracted light component from the digital pixel data, processing of further increasing the degree of noise removal or the degree of edge enhancement is performed. With this arrangement, even in a case where the flare component or the diffracted light component is removed, there is no possibility that the S/N ratio of the taken image decreases.

### (Third embodiment)

In a third embodiment, each pixel has a divided structure.

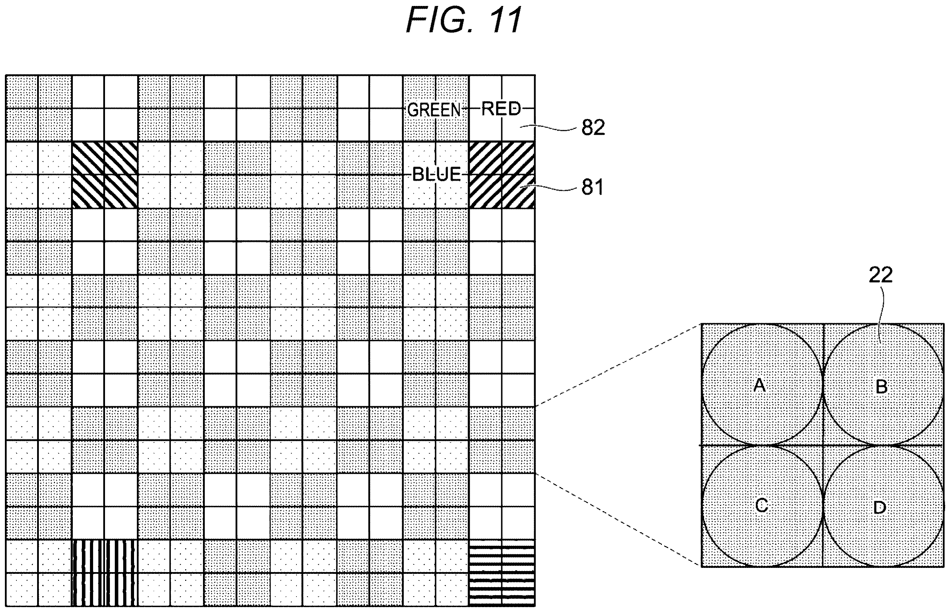

Fig. 11 is a plan view illustrating an example of a pixel array of a plurality of polarization pixels 81 and a plurality of non-polarization pixels 82 according to the third embodiment. As illustrated in Fig. 11, each of the polarization pixels 81 and each of the non-polarization pixels 82 are divided into four. More specifically, each of photoelectric conversion units 8a includes a plurality of divided photoelectric conversion units, and light polarized by a plurality of polarizing elements 8b is incident on the plurality of divided photoelectric conversion units in some of the photoelectric conversion units 8a. Note that, although Fig. 11 illustrates an example in which each of the polarization pixels 81 and each of the non-polarization pixels 82 are divided into four, each of the polarization pixels 81 and each of the non-polarization pixels 82 may be divided into any number equal to or greater than two.

The plurality of polarization pixels 81 is provided corresponding to positions and sizes of the plurality of non-polarization pixels 82, and in the example in Fig. 11, one polarization pixel 81 is provided for five non-polarization pixels 82 in each of a horizontal direction and a vertical direction. Each of the polarization pixels 81 is divided into four similarly to each of the non-polarization pixels 82. Polarization patterns of four divided pixels in the same polarization pixel 81 are the same. Although the example in Fig. 11 is a case where four types of polarization pixels 81 having different polarization patterns are included, the number of types of the polarization pixels 81 is arbitrary as long as the number of types is three or more. In the present specification, each pixel obtained by dividing each of the polarization pixels 81 or each of the non-polarization pixels 82 into four is referred to as a divided pixel.

As illustrated in an enlarged view on a right side of Fig. 11, an on-chip lens 22 may be separately provided for each of the four divided pixels that constitute each of the non-polarization pixels 82.

Although, in the example in Fig. 11, a size of each of the polarization pixels 81 is the same as a size of each of the non-polarization pixels 82, and each of the polarization pixels 81 is disposed according to a location where each of the non-polarization pixels 82 is disposed, the size of each of the polarization pixels 81 or a location where each of the polarization pixels 81 is disposed may be different from the size of each of the non-polarization pixels 82 or a location where each of the non-polarization pixels 82 is disposed.

In a case of Fig. 11, light polarized by a corresponding polarizing element 8b is input to a pixel region in a photoelectric conversion unit 8a allocated as a polarization pixel 81, and therefore an output value of the photoelectric conversion unit 8a in this pixel region decreases. Therefore, it is necessary for the defect correction unit 37 illustrated in Fig. 8 to perform defect correction for correcting an output value of the polarization pixel 81 by using an output value of a non-polarization pixel 82 around each of the polarizing elements 8b.

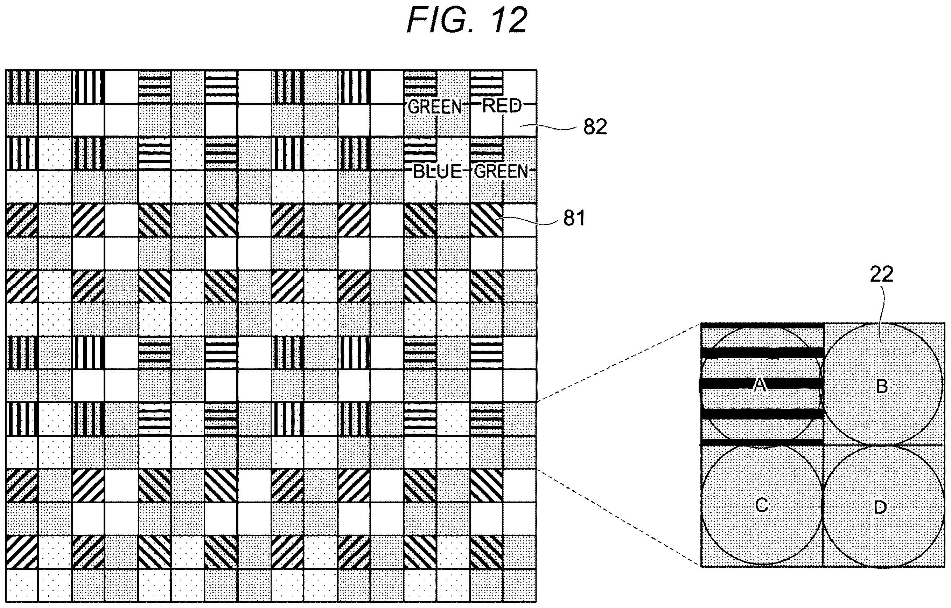

Fig. 12 is a plan view illustrating a first modification of the divided structure. In Fig. 12, three of four divided pixels that constitute one pixel are utilized for photoelectric conversion of a corresponding non-polarization pixel 82, and a remaining one divided pixel is utilized as a polarization pixel 81. More specifically, a photoelectric conversion unit 8a includes a plurality of divided photoelectric conversion units, and light polarized by a plurality of polarizing elements 8b is incident on some of the divided photoelectric conversion units in any of the photoelectric conversion units 8a. With this arrangement, a polarization pixel 81 and a non-polarization pixel 82 are partially disposed inside each pixel. In this case, as illustrated in an enlarged view on a right side of Fig. 12, an on-chip lens is provided corresponding to each of the four divided pixels that constitute one pixel.

One polarization pixel 81 is provided for a plurality of non-polarization pixels 82 in the example in Fig. 11, whereas a non-polarization pixel 82 and a polarization pixel 81 are provided for each pixel in the example in Fig. 12. Therefore, in the example in Fig. 12, polarization information in a photoelectric conversion unit 8a can be acquired more accurately than in the example in Fig. 11.

Furthermore, although four types of polarization pixels 81 having four types of polarization patterns are uniformly disposed in the example in Fig. 12, the number of types of the polarization patterns is only required to be three or more, and is not limited to four.

In a case of Fig. 12, for each pixel, a pixel output value is decided on the basis of output values of divided photoelectric conversion units for three divided pixels that are among two divided pixels each in the vertical and horizontal directions and are utilized as non-polarization pixels 82, and a correction amount is decided on the basis of an output value of a divided photoelectric conversion unit for one divided pixel that is among the two divided pixels each in the vertical and horizontal directions and is utilized as a polarization pixel 81. Thus, in the example in Fig. 12, each pixel partially includes non-polarization pixels 82, and therefore it is not necessary to perform defect correction, and signal processing can be simplified.

Thus, by allocating a polarization pixel 81 and a non-polarization pixel 82 to a plurality of divided pixels obtained by dividing each pixel into a plurality of pixels, color information and polarization information can be output by a non-polarization pixel 82c in each pixel, and resolution is not lost, and therefore defect correction processing is unnecessary. Furthermore, a correction amount based on a flare component or diffracted light component can be calculated by a polarization pixel 81 allocated to a part of each pixel, and the flare component or the diffracted light component can be removed from a taken image by subtracting the correction amount from digital pixel data.

In the example in Fig. 12, a polarization pixel 81 is allocated to one of four divided pixels obtained by dividing each pixel, and therefore a size of the polarization pixel 81 is very small. Although the polarization pixel 81 includes, for example, line and space parts as illustrated in Fig. 5, it is not easy to accurately make shapes of line parts 8d uniform or accurately align intervals between two adjacent line parts 8d by using microfabrication technology. Therefore, a size of the polarization pixel 81 may be larger than a size of the non-polarization pixels 82.

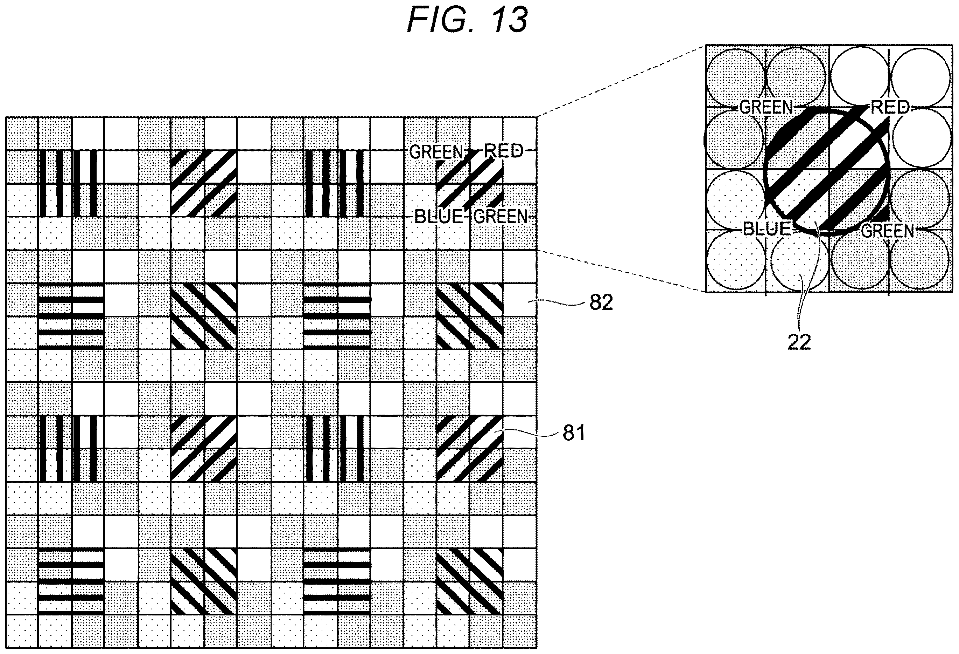

Fig. 13 is a plan view illustrating a second modification of the divided structure. In Fig. 13, one polarization pixel 81 is disposed so as to extend over four pixels disposed adjacent to one another. More specifically, a photoelectric conversion unit 8a includes a plurality of divided photoelectric conversion units, and light polarized by a polarizing element 8b is incident on a divided conversion unit for each unit of two or more photoelectric conversion units 8a. A size of the polarization pixel 81 is twice a size of a pixel in the vertical and horizontal directions, and an area of the polarization pixel 81 is four times an area of the pixel. In the example in Fig. 13, three of the four divided pixels that constitute one pixel are allocated to non-polarization pixels 82 and used for normal photoelectric conversion, and a remaining one divided pixel is allocated to a polarization pixel 81 and used for acquisition of polarization information. Therefore, similarly to Fig. 12, each pixel has divided pixels utilized as non-polarization pixels 82, and therefore it is not necessary to perform defect correction

As illustrated in an enlarged view on a right side of Fig. 13, for each of the three divided pixels that are among four divided pixels obtained by dividing one pixel and are utilized as non-polarization pixels 82, an on-chip lens 22 is provided separately. Remaining one divided pixel is, along with other three divided pixels adjacent thereto, provided with one large on-chip lens 22, and is utilized as a polarization pixel 81. Thus, by producing a large polarizing element 8b by utilizing a region of four divided pixels disposed adjacent to one another and providing an on-chip lens 22 corresponding to a size of the polarizing element 8b, the polarizing element 8b can be easily manufactured, and highly reliable polarization information can be acquired.

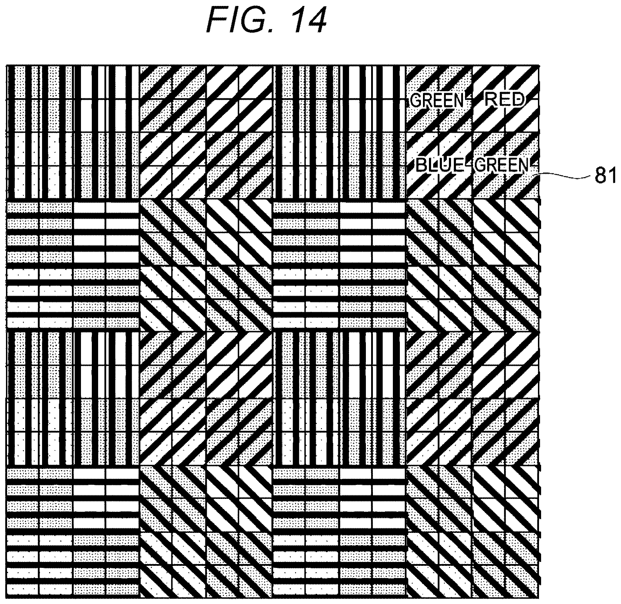

Fig. 14 is a plan view illustrating a third modification of the divided structure. In Fig. 14, a polarization pixel 81 is disposed on an entire pixel region. More specifically, a plurality of photoelectric conversion units 8a has a plurality of divided photoelectric conversion units, and light polarized by a plurality of polarizing elements 8b is incident on the plurality of photoelectric conversion units 8a. That is, in the example in Fig. 14, only polarization pixels 81 exist, and non-polarization pixels 82 do not exist. In the example in Fig. 14, each pixel is divided into four divided pixels, and all of the divided pixels are used as polarization pixels 81.

In a case of Fig. 14, a polarization pixel 81 is allocated to all of the divided pixels in all the pixels, and therefore output values of the photoelectric conversion units 8a decrease uniformly. Therefore, gain adjustment processing for entirely increasing the output values of the photoelectric conversion units 8a may be performed. Although an S/N ratio may decrease by performing the gain adjustment processing, it is possible to generate highly reliable digital pixel data by performing processing of further increasing a degree of the noise reduction processing or of the edge enhancement processing, or the like.

Furthermore, by providing a polarizing element 8b in association with an entire region of a photoelectric conversion unit 8a as illustrated in Fig. 14, it is possible to acquire polarization information in consideration of an effect of flare or diffracted light incident on an arbitrary location in the photoelectric conversion unit 8a. Therefore, accuracy of the correction amount extracted by a flare extraction unit 35 can be improved.

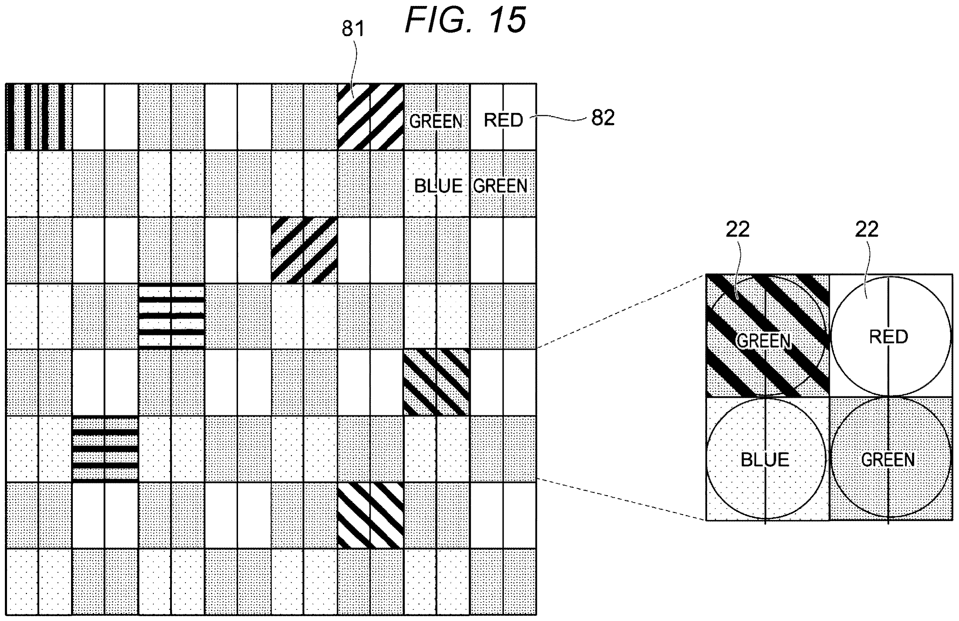

Fig. 15 is a plan view illustrating a fourth modification of the divided structure. The example in Fig. 15 is common to Fig. 3 and the like in that a polarization pixel 81 is disposed between non-polarization pixels 82, and is different from the above-described other divided structures in that each of the non-polarization pixels 82 is divided into two right and left divided pixels. More specifically, a photoelectric conversion unit 8a has a plurality of divided photoelectric conversion units divided into two or more in one direction and capable of detecting phase difference information, and light polarized by a polarizing element 8b is incident on a plurality of divided photoelectric conversion units in any of the photoelectric conversion units 8a. Each of the divided pixels has, for example, a vertically long rectangular shape. The two divided pixels can be used for detecting phase difference information. For example, focusing can be performed on the basis of the phase difference information.

Each of the polarization pixels 81 provided at a ratio of 1 to a plurality of non-polarization pixels 82 (five non-polarization pixels 82, for example) in Fig. 15 has two divided pixel sizes. As described above, because a polarizing element 8b has line and space parts, microfabrication thereof is not easy. However, a polarizing element 8b in Fig. 15 has twice a size of a divided pixel, and therefore manufacturing thereof is relatively easy, and a manufacturing defect is less likely to occur. However, because an output value of a photoelectric conversion unit 8a decreases in a pixel region where a polarizing element 8b is disposed, it is necessary to perform defect correction processing by using a pixel value of a photoelectric conversion unit 8a corresponding to a surrounding non-polarization pixel 82.

Figs. 11 to 15 described above illustrate representative examples of the divided structure, and there may be a divided structure other than the illustrated divided structures. The present embodiment can be applied to all divided structures, and a photoelectric conversion unit 8a may be divided into any shapes and sizes. Therefore, a division shape and division size of the non-polarization pixels 82, and the division number of the non-polarization pixels 82 are arbitrary. Furthermore, the polarization pixels 81 may be divided or may not be divided.

Thus, in the third embodiment, because at least the non-polarization pixels 82 have a divided structure, if a part of the divided pixels in each pixel is allocated to a polarization pixel 81 to acquire polarization information, and remaining divided pixels are allocated to non-polarization pixels 82 to acquire color information, it is not necessary to perform defect correction on each pixel.

Furthermore, not only polarization information but also phase difference information can be detected by each pixel having a divided structure. Moreover, if the non-polarization pixels 82 have a divided structure and the polarization pixels 81 do not have a divided structure, a size of the polarization pixel 81 can be larger than a size of the non-polarization pixels 82, and therefore the polarizing elements 8b can be easily manufactured.

### (Fourth embodiment)

In a fourth embodiment, a structure of a display unit 2 is characterized in an electronic apparatus 1 in which a camera module 3 is disposed on a side opposite to a display surface of the display unit 2.

As described above, a circularly polarizing plate 5 is provided inside the display unit 2 in order to improve visibility. However, because the circularly polarizing plate 5 shields at least a portion of light, if subject light that has passed through the display unit 2 is imaged by the camera module 3, a problem such as a dark taken image occurs. Similarly, transmittance of a touch sensor inside the display unit 2, a display panel 4 such as an OLED unit, and the like is not very high. Therefore, in the present embodiment, a through hole is provided in a region overlapping the camera module 3 in the display unit 2 in a front-back direction.

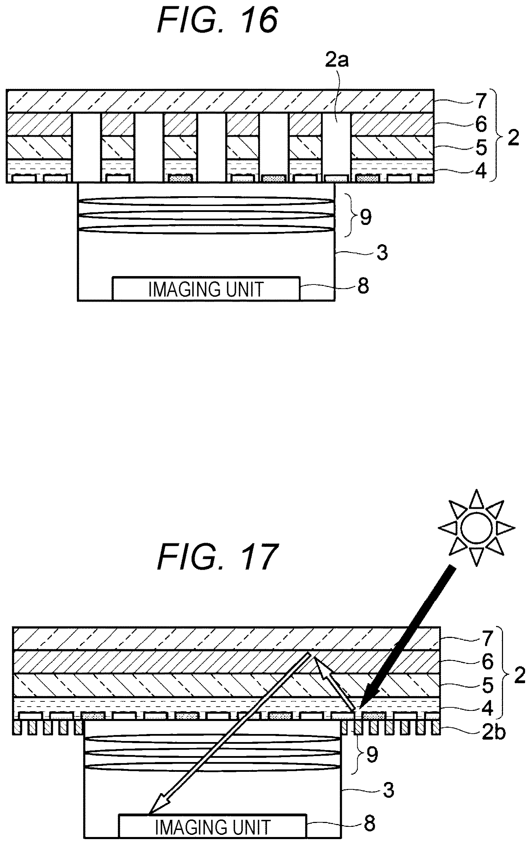

Fig. 16 is a schematic cross-sectional view of the electronic apparatus 1 according to the fourth embodiment. The display unit 2 in the electronic apparatus 1 in Fig. 16 has a plurality of through holes 2a in portions overlapping the camera module 3 in the front-back direction. These through holes 2a are provided in a plurality of layers having low transmittance such as the touch sensor, circularly polarizing plate 5, and display panel 4 in the display unit 2. A size of a diameter of a through hole 2a varies with each layer. For example, the circularly polarizing plate 5 has a through hole 2a having a diameter of the same size as a diameter of an imaging unit 8 of the camera module 3. Meanwhile, the touch sensor and the display panel 4 may be provided with a plurality of small through holes 2a within the diameter size of the imaging unit 8 so as not to adversely affect display or touch sensitivity of the display unit 2 as much as possible.

Although providing these through holes 2a may slightly affect visibility or touch sensitivity of a display screen 1a of the display unit 2, there is almost no problem in practical use, because a size of a diameter of the camera module 3 is about merely a few mm. By providing these through holes 2a, transmittance of subject light passing through the display unit 2 is improved, and image quality of an image taken by the camera module 3 can be improved.

Other than the example in Fig. 16, various kinds of examples of characterizing a structure of the display unit 2 can be considered. Fig. 17 is a cross-sectional view of a first modification in which a structure of the display unit 2 is characterized. In the display unit 2 in Fig. 17, a polarization member 2b that polarizes light in a specific direction is disposed on a back surface of the display panel 4. In the example in Fig. 17, the polarization member 2b is disposed on a back surface side of a region not vertically overlapping the camera module 3 in the display panel 4.

When light incident on the display unit 2 is incident on the polarization member 2b, the light is polarized in a specific direction when reflected. The reflected light is further reflected by another layer of the display unit 2, for example, and is incident on the imaging unit 8. Because the reflected light is polarized in a specific direction when being incident on the imaging unit 8, polarization information of the light polarized by the polarization member 2b can be reliably acquired by previously providing at least some of a plurality of polarizing elements 8b with the same polarization characteristic as a polarization characteristic of the polarization member 2b.

Thus, by providing the polarization member 2b polarized in a specific direction in the display unit 2, light incident on the imaging unit 8 can be polarized in a specific direction, and a flare component or a diffraction component can be more reliably extracted by a plurality of polarization pixels 81.

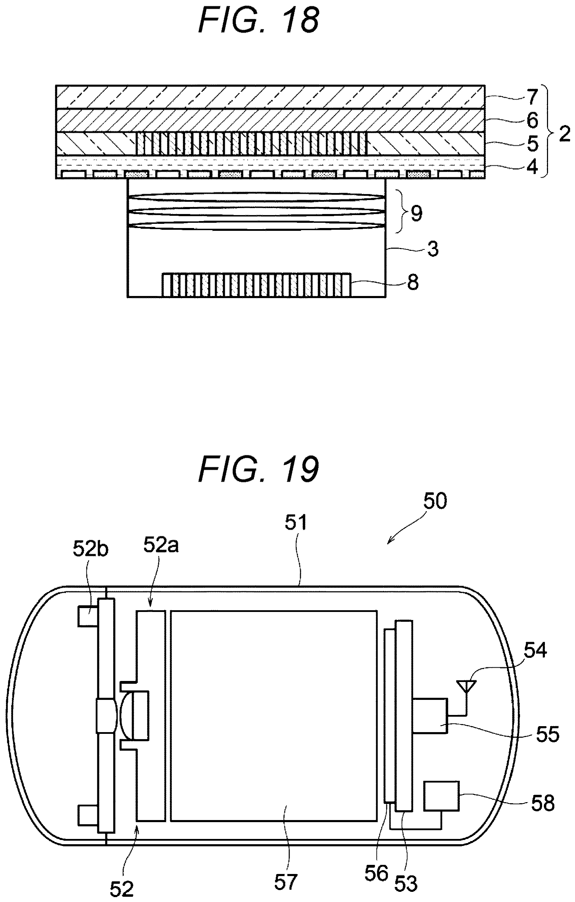

Fig. 18 is a cross-sectional view of a second modification in which a structure of the display unit 2 is characterized. In the display unit 2 in Fig. 18, the polarization member 2b polarized in a specific direction is provided in a region in the circularly polarizing plate 5, the region overlapping the camera module 3 in the front-back direction. Originally, the camera module 3 intends to image light incident substantially parallel to an optical axis. Therefore, the polarization member 2b that polarizes light in a direction substantially parallel to the optical axis is provided beforehand in, for example, a region overlapping the camera module 3 of the circularly polarizing plate 5 in the front-back direction. With this arrangement, light passing through inside the region is polarized in a direction substantially parallel to the optical axis and then is incident on the imaging unit 8. If the plurality of polarizing elements 8b in the imaging unit 8 has the same polarization characteristic as the polarization characteristic of the polarization member 2b, light incident on the imaging unit 8 is reliably received by the plurality of polarization pixels 81.

Thus, in the fourth embodiment, by partially processing the display unit 2, transmittance when light passes through the display unit 2 can be improved, and image quality of an image taken by the camera module 3 can be improved. As a more specific example, by providing an opening in a region overlapping the camera module 3 in the front-back direction, transmittance when light passes through the display unit 2 can be improved, and image quality of an image taken by the camera module 3 can be improved. Furthermore, by providing the polarization member 2b polarized in a specific direction in at least a part of the display unit 2, light that is repeatedly reflected in the display unit 2 and then is incident on the imaging unit 8 can be polarized in a specific direction, and the light can be reliably received by the polarization pixel 81.

### (Fifth embodiment)

Various kinds of candidates can be considered as specific candidates of an electronic apparatus 1 including a configuration described in the first to fourth embodiments described above. For example, Fig. 19 is a plan view in a case where the electronic apparatus 1 according to the first to fourth embodiments is applied to a capsule endoscope 50. The capsule endoscope 50 in Fig. 19 includes, in a housing 51 with both end surfaces having a hemispherical shape and a central portion having a cylindrical shape for example, a camera (ultracompact camera) 52 for capturing an image of inside a body cavity, a memory 53 for recording image data captured by the camera 52, and a wireless transmitter 55 for transmitting the recorded image data to an outside via an antenna 54 after the capsule endoscope 50 is discharged to outside of a test subject.

Furthermore, a central processing unit (CPU) 56 and a coil (magnetic force/current conversion coil) 57 are provided in the housing 51. The CPU 56 controls image capturing by the camera 52 and operation of accumulating data in the memory 53, and controls data transmission from the memory 53 to a data reception device (not illustrated) outside the housing 51 by the wireless transmitter 55. The coil 57 supplies power to the camera 52, the memory 53, the wireless transmitter 55, the antenna 54, and a light source 52b as described later.

Moreover, the housing 51 is provided with a magnetic (reed) switch 58 for sensing that the capsule endoscope 50 is set on the data reception device. The CPU 56 supplies power from the coil 57 to the wireless transmitter 55 at a time point when the reed switch 58 senses the set on the data reception device and data transmission becomes possible.

The camera 52 has, for example, an imaging element 52a including an objective optical system 9 for capturing an image in a body cavity, and a plurality of light sources 52b for illuminating the body cavity. Specifically, the camera 52 includes a complementary metal oxide semiconductor (CMOS) sensor, a charge coupled device (CCD), or the like including a light emitting diode (LED) for example, as a light source 52b.

A display unit 2 in the electronic apparatus 1 according to the first to fourth embodiments is a concept including a luminous object such as a light source 52b in Fig. 19. The capsule endoscope 50 in Fig. 19 includes, for example, two light sources 52b, and these light sources 52b can be configured by a display panel 4 having a plurality of light source units or an LED module having a plurality of LEDs. In this case, by disposing an imaging unit 8 of the camera 52 below the display panel 4 or the LED module, a restriction on layout arrangement of the camera 52 is reduced, and a smaller capsule endoscope 50 can be implemented.

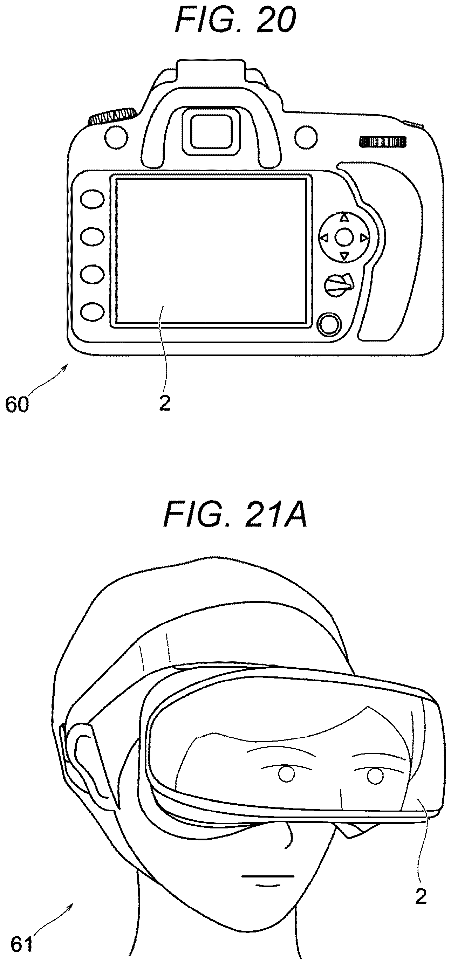

Furthermore, Fig. 20 is a rear view in a case where an electronic apparatus 1 according to the first to fourth embodiments is applied to a digital single-lens reflex camera 60. The digital single-lens reflex camera 60 or a compact camera includes a display unit 2 that displays a preview screen on a rear surface on a side opposite to a lens. A camera module 3 may be disposed on a side opposite to a display surface of the display unit 2 so that a face image of a person who captures the face image can be displayed on a display screen 1a of the display unit 2. In an electronic apparatus 1 according to the first to fourth embodiments, the camera module 3 can be disposed in a region overlapping the display unit 2, and therefore it is not necessary to provide the camera module 3 on a frame part of the display unit 2, and a size of the display unit 2 can be increased as much as possible.

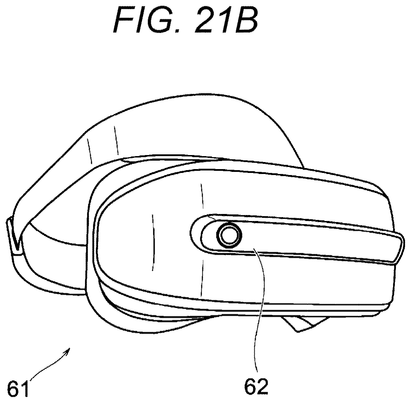

Fig. 21A is a plan view illustrating an example in which the electronic apparatus 1 according to the first to fourth embodiments is applied to a head mounted display (hereinafter, HMD) 61. The HMD 61 in Fig. 21A is utilized for virtual reality (VR), augmented reality (AR), mixed reality (MR), substitutional reality (SR), or the like. As illustrated in Fig. 21B, a current HMD is equipped with a camera 62 on an outer surface thereof, and there is a problem that, although a wearer of the HMD can visually recognize a surrounding image, a human around the wearer of the HMD cannot recognize expression of eyes or face of the wearer of the HMD.

Therefore, in Fig. 21A, the display surface of the display unit 2 is provided on an outer surface of the HMD 61, and the camera module 3 is provided on a side opposite to the display surface of the display unit 2. With this arrangement, an image of the expression of the face of the wearer captured by the camera module 3 can be displayed on the display surface of the display unit 2, and the human around the wearer can grasp the expression of the face of or movement of the eyes of the wearer in real time.

In a case of Fig. 21A, the camera module 3 is provided on a back surface side of the display unit 2, and therefore there is no restriction on an installation location of the camera module 3, and design of the HMD 61 can be highly flexible. Furthermore, because the camera can be disposed at an optimum position, it is possible to prevent a problem such as deviation of a line of sight of the wearer displayed on the display surface.

Thus, in a fifth embodiment, the electronic apparatus 1 according to the first to fourth embodiments can be used for various kinds of applications, and a utility value can be enhanced.

### (Sixth embodiment)

There may be a case where a likelihood of occurrence of flare or diffraction is different depending on a type of a light source of light incident on an electronic apparatus 1 or display luminance of a display unit 2. Therefore, the type of the light source may be estimated in calculating a correction amount of a flare component or a diffracted light component.

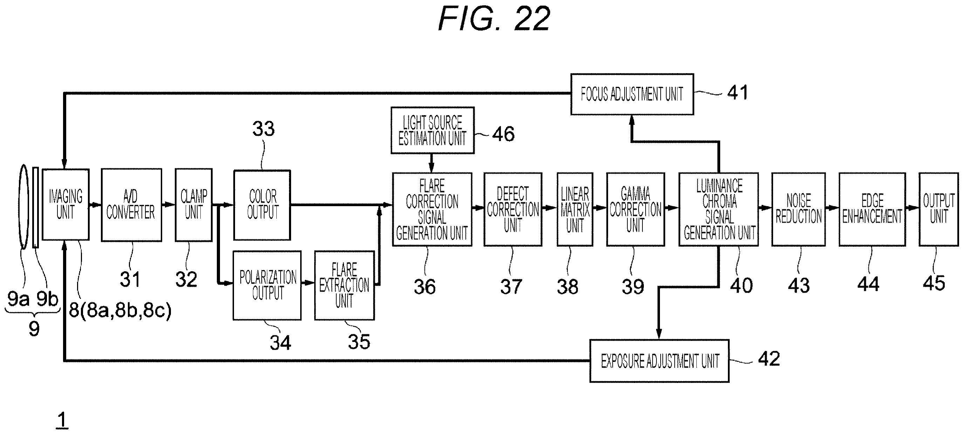

Fig. 22 is a block diagram illustrating a schematic configuration of the electronic apparatus 1 according to a sixth embodiment. The electronic apparatus 1 in Fig. 22 includes a light source estimation unit 46 in addition to the configuration in Fig. 8. The light source estimation unit 46 estimates a light source of light incident on the display unit 2. The light source estimation unit 46 may estimate the light source on the basis of a difference in sensitivity of each RGB color photoelectrically converted by a photoelectric conversion unit 8a, or may estimate the light source by using an illuminance sensor, a multispectral sensor, or the like. Furthermore, a GPS sensor mounted on the electronic apparatus 1 may discriminate whether the electronic apparatus 1 is indoors or outdoors to estimate whether the light source is sunlight or illumination light. Furthermore, a tilt angle of the electronic apparatus 1 may be determined by a gyro sensor mounted on the electronic apparatus 1, and the light source may be estimated on the basis of the tilt angle.

A flare correction signal generation unit 36 adjusts a correction amount of a taken image photoelectrically converted by a plurality of non-polarization pixels 82 on the basis of the light source estimated by the light source estimation unit 46. More specifically, a mathematical formula for calculating the correction amount may be changed for each type of light source. Furthermore, the correction amount may be individually adjusted for each RGB color for each type of light source.

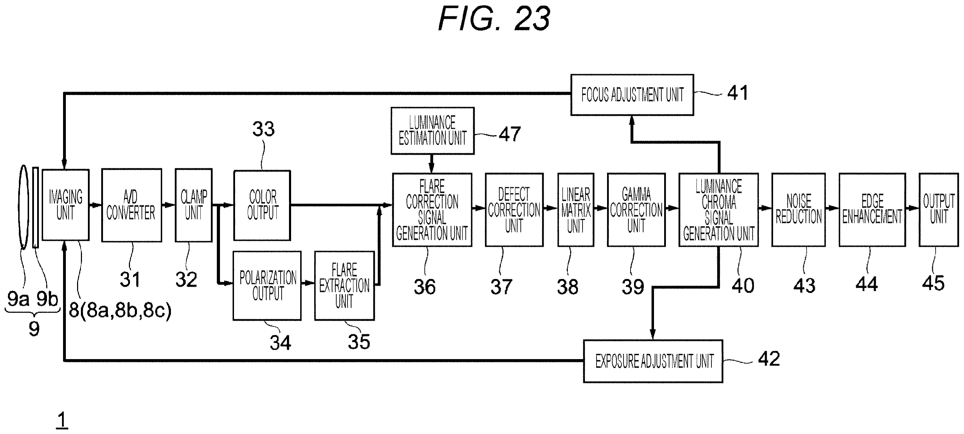

Fig. 23 is a block diagram illustrating a schematic configuration of the electronic apparatus 1 according to a modification of the sixth embodiment. The electronic apparatus 1 in Fig. 23 includes a luminance estimation unit 47 in addition to the configuration in Fig. 8. The luminance estimation unit 47 estimates the display luminance of the display unit 2. The luminance estimation unit 47 estimates the display luminance of the display unit 2 on the basis of, for example, a signal from an unillustrated display control unit that performs display control of the display unit 2.

The flare correction signal generation unit 36 adjusts a correction amount of a taken image photoelectrically converted by the plurality of non-polarization pixels 82 on the basis of the display luminance of the display unit 2 estimated by the luminance estimation unit 47. More specifically, the correction amount may be individually adjusted for each color on the basis of luminance of each RGB color displayed on the display unit 2.

Furthermore, the electronic apparatus 1 including both the light source estimation unit 46 in Fig. 22 and the luminance estimation unit 47 in Fig. 23 is also conceivable. In this case, the flare correction signal generation unit 36 adjusts the correction amount on the basis of the type of the light source and the display luminance of the display unit 2.

Thus, in the sixth embodiment, a correction amount for correcting an effect of a flare component or a diffracted light component is adjusted in consideration of a type of a light source incident on the electronic apparatus 1 or display luminance of the display unit 2, and therefore the flare component and the diffracted light component can be more appropriately removed from a taken image.

### (Seventh embodiment)

In an electronic apparatus 1 according to a seventh embodiment, an optical system 9 of a camera module 3 is different from an optical system 9 of the first to sixth embodiments.

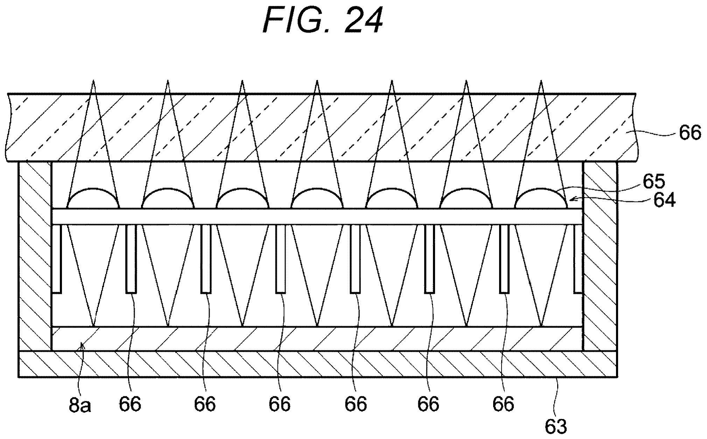

Fig. 24 is a diagram illustrating a cross-sectional structure of an imaging unit 8 of the camera module 3 mounted on the electronic apparatus 1 according to the seventh embodiment. The imaging unit 8 in Fig. 24 has a microlens array 64, instead of a single lens or a lens group in which single lenses are arranged in an optical axis direction.

More specifically, the imaging unit 8 in Fig. 24 has a photoelectric conversion unit 8a disposed along a bottom surface of a housing 63, the microlens array 64 disposed above the photoelectric conversion unit 8a, a plurality of light shielding bodies 66 disposed between microlenses 65 adjacent to one another, and a light guide plate 67 disposed above the microlens array 64.

Thus, by providing the microlens array 64 as the optical system 9 of the imaging unit 8, it is possible to prevent an effect of an adjacent pixel and to reduce color blurring.

### (Eighth embodiment)

Although examples of removing flare or diffracted light has been described in the first to seventh embodiments described above, an electronic apparatus 1 according to the present disclosure is applicable not only to removal of flare or diffracted light but also, for example, to a purpose of removing shininess of a subject. In an electronic apparatus 1 according to the present embodiment, a camera module 3 can be disposed on a side opposite to a display surface of a display unit 2, and therefore, in a case where a wide-angle or fisheye lens is attached to the camera module 3, an entire display surface of the display unit 2 can be imaged by the camera module 3. With this arrangement, it is possible to detect a wet finger that is often erroneously recognized by an existing touch panel 6, and in addition, it is possible to remove shininess caused by a wet finger or to detect irregularities of a fingerprint, enabling touch operation or fingerprint authentication.

More specifically, a plurality of polarization pixels 81 having a plurality of polarizing elements 8b may acquire polarization information caused by a shininess component included in subject light. In this case, on the basis of the polarization information, a flare extraction unit 35 in Fig. 8 extracts a correction amount based on the shininess component. Then, a flare correction signal generation unit 36 generates an image obtained by removing the shininess component from a subject image.

Furthermore, although it is assumed that a camera module 3 is disposed on a side opposite to a display surface of a display unit 2 in each of the above-described embodiments, in a case where there is a reflector plate in a lowermost layer of a display panel 4 such as an OLED unit, a portion of the reflector plate may be hollowed out to dispose the camera module 3 on the hollowed portion, or the camera module 3 may be disposed so as to bite into a portion of the display panel 4.

Note that the present technology can have the following configurations.
(1) An electronic apparatus including
   a display unit, and an imaging unit disposed on a side opposite to a display surface of the display unit,
   in which the imaging unit has
   a plurality of photoelectric conversion units that photoelectrically converts light incident via the display unit, and
   a plurality of polarizing elements disposed on a light incident side of at least one photoelectric conversion unit of the plurality of photoelectric conversion units.
(2) The electronic apparatus according to (1), further including a correction unit that corrects, on the basis of polarization information polarized in the plurality of polarizing elements and photoelectrically converted in the photoelectric conversion unit, a taken image photoelectrically converted.
(3) The electronic apparatus according to (2), in which the correction unit removes a component obtained by at least either reflected light or diffracted light being incident on the plurality of photoelectric conversion units and imaged, the reflected light or diffracted light being generated when light passes through the display unit.
(4) The electronic apparatus according to (2) or (3), in which the correction unit corrects digital pixel data photoelectrically converted in the photoelectric conversion unit and digitized, by performing, on the digital pixel data, processing of subtracting a correction amount based on polarization information data obtained by digitizing the polarization information.
(5) The electronic apparatus according to any one of (2) to (4), further including a polarization member that is provided on the display unit and polarizes incident light in a specific direction,
   in which at least one of the plurality of polarizing elements passes light polarized by the polarization member, and
   the correction unit corrects, on the basis of the polarization information that is polarized by the polarization member, passes though the polarizing element, and is photoelectrically converted in the photoelectric conversion unit, a taken image photoelectrically converted in the plurality of photoelectric conversion units.
(6) The electronic apparatus according to any one of (2) to (4), further including a light source estimation unit that estimates a type of light source of light incident on the display unit,
   in which the correction unit adjusts, on the basis of a type of light source estimated in the light source estimation unit, a correction amount of a taken image photoelectrically converted in the plurality of photoelectric conversion units.
(7) The electronic apparatus according to any one of (2) to (4), further including a luminance estimation unit that estimates display luminance of the display unit,
   in which the correction unit adjusts, according to display luminance of the display unit, a correction amount of a taken image photoelectrically converted in the plurality of photoelectric conversion units.
(8) The electronic apparatus according to any one of (2) to (7), further including a signal processing unit that performs at least one of exposure processing, focus adjustment processing, or white balance adjustment processing on a taken image corrected in the correction unit.
(9) The electronic apparatus according to any one of (2) to (7), further including
   a signal processing unit that performs at least one type of signal processing on a taken image corrected in the correction unit, and
   a parameter adjustment unit that adjusts a parameter for when performing signal processing on the taken image according to a correction amount by which the correction unit corrects the taken image.
(10) The electronic apparatus according to (9),
   in which signal processing performed by the signal processing unit includes at least either noise reduction processing that removes a noise component included in the taken image, or edge enhancement processing that enhances an edge in the taken image, and
   the parameter adjustment unit adjusts, according to the correction amount, a parameter for when performing at least either the noise reduction processing or the edge enhancement processing.
(11) The electronic apparatus according to (10), in which the parameter adjustment unit performs, for a taken image having a larger correction amount, at least either processing of further increasing a degree of noise removal in the noise reduction processing, or processing of further increasing a degree of edge enhancement in the edge enhancement processing.
(12) The electronic apparatus according to any one of (9) to (11), in which the signal processing unit performs signal processing including exposure adjustment processing, and, when performing the exposure adjustment processing, performs exposure adjustment so that output values of the plurality of photoelectric conversion units do not saturate.
(13) The electronic apparatus according to any one of (1) to (12), further including a defect correction unit that corrects, by using output values of surrounding two or more of the photoelectric conversion units, an output value of the photoelectric conversion unit on which light polarized by the polarizing element is incident.
(14) The electronic apparatus according to any one of (1) to (13), further including an imaging device having the photoelectric conversion unit and an optical system that condenses light on the photoelectric conversion unit,
   in which the imaging device is disposed on a side opposite to a vicinity of a substantially central portion of a display surface of the display unit.
(15) The electronic apparatus according to any one of (1) to (14), further including a defect correction unit that corrects an output value of a photoelectric conversion unit of which output value saturates, for a photoelectric conversion unit of which output value saturates among the plurality of photoelectric conversion units, on the basis of polarization information that is polarized in one or more of the polarizing elements disposed around the photoelectric conversion unit, and is photoelectrically converted in the photoelectric conversion unit.
(16) The electronic apparatus according to any one of (1) to (15),
   in which the photoelectric conversion unit has a plurality of divided photoelectric conversion units, and
   light polarized by the plurality of polarizing elements is incident on the plurality of divided photoelectric conversion units in some of the photoelectric conversion units.
(17) The electronic apparatus according to any one of (1) to (15),
   in which the photoelectric conversion unit has a plurality of divided photoelectric conversion units, and
   light polarized by the polarizing element is incident on some of the divided photoelectric conversion units in any of the photoelectric conversion units.
(18) The electronic apparatus according to any one of (1) to (15),
   in which the photoelectric conversion unit has a plurality of divided photoelectric conversion units, and
   light polarized by the polarizing element is incident on the divided photoelectric conversion unit for each unit of two or more of the photoelectric conversion units.
(19) The electronic apparatus according to any one of (1) to (15),
   in which the plurality of photoelectric conversion units has a plurality of divided photoelectric conversion units, and
   light polarized by the plurality of polarizing elements is incident on the plurality of photoelectric conversion units.
(20) The electronic apparatus according to any one of (1) to (15),
   in which the photoelectric conversion unit has a plurality of divided photoelectric conversion units divided into two or more in one direction and capable of detecting phase difference information, and
   light polarized by the polarizing element is incident on the plurality of divided photoelectric conversion units in any of the photoelectric conversion units.

Aspects of the present disclosure are not limited to the above-described individual embodiments, and include various modifications that may be conceived by those skilled in the art, and the effects of the present disclosure are not limited to the above-described content. That is, various additions, modifications, and partial deletions can be made without departing from the conceptual ideas and spirit of the present disclosure derived from the content defined in the claims and equivalents thereof.

### REFERENCE SIGNS LIST

- 1: Electronic apparatus
- 1a: Display screen
- 1b: Bezel
- 2: Display unit
- 3: Camera module
- 4: Display panel
- 5: Circularly polarizing plate
- 6: Touch panel
- 7: Cover glass
- 8: Imaging unit
- 8a: Photoelectric conversion unit
- 8b: Polarizing element
- 8d: Line part
- 8f: Light reflection layer
- 8g: Insulation layer
- 8h: Light absorption layer
- 9: Optical system
- 11: Substrate
- 11a: First surface
- 11b: Second surface
- 12: Wiring layer
- 13: Interlayer insulation film
- 14: Planarization layer
- 15: Light-shielding layer
- 16: Base insulation layer
- 17: Insulation layer
- 31: A/D converter
- 32: Clamp unit
- 33: Color output unit
- 34: Polarization output unit
- 35: Flare extraction unit
- 36: Flare correction signal generation unit
- 37: Defect correction unit
- 38: Linear matrix unit
- 39: Gamma correction unit
- 40: Luminance chroma signal generation unit
- 41: Focus adjustment unit
- 42: Exposure adjustment unit
- 43: Noise reduction unit
- 44: Edge enhancement unit
- 45: Output unit
- 81: Change element
- 82: Non-polarization pixel

## Claims

1. An electronic apparatus comprising:
a display unit; and
an imaging unit disposed on a side opposite to a display surface of the display unit,
wherein the imaging unit has
a plurality of photoelectric conversion units that photoelectrically converts light incident via the display unit, and
a plurality of polarizing elements disposed on a light incident side of at least one photoelectric conversion unit of the plurality of photoelectric conversion units.

2. The electronic apparatus according to claim 1, further comprising a correction unit that corrects, on a basis of polarization information polarized in the plurality of polarizing elements and photoelectrically converted in the photoelectric conversion unit, a taken image photoelectrically converted in the plurality of photoelectric conversion units.

3. The electronic apparatus according to claim 2, wherein the correction unit removes a component obtained by at least either reflected light or diffracted light being incident on the plurality of photoelectric conversion units and imaged, the reflected light or diffracted light being generated when light passes through the display unit.

4. The electronic apparatus according to claim 2, wherein the correction unit corrects digital pixel data photoelectrically converted in the photoelectric conversion unit and digitized, by performing, on the digital pixel data, processing of subtracting a correction amount based on polarization information data obtained by digitizing the polarization information.

5. The electronic apparatus according to claim 2, further comprising a polarization member that is provided on the display unit and polarizes incident light in a specific direction,
wherein at least one of the plurality of polarizing elements passes light polarized by the polarization member, and
the correction unit corrects, on a basis of the polarization information that is polarized by the polarization member, passes though the polarizing element, and is photoelectrically converted in the photoelectric conversion unit, a taken image photoelectrically converted in the plurality of photoelectric conversion units.

6. The electronic apparatus according to claim 2, further comprising a light source estimation unit that estimates a type of light source of light incident on the display unit,
wherein the correction unit adjusts, on a basis of a type of light source estimated in the light source estimation unit, a correction amount of a taken image photoelectrically converted in the plurality of photoelectric conversion units.

7. The electronic apparatus according to claim 2, further comprising a luminance estimation unit that estimates display luminance of the display unit,
wherein the correction unit adjusts, according to display luminance of the display unit, a correction amount of a taken image photoelectrically converted in the plurality of photoelectric conversion units.

8. The electronic apparatus according to claim 2, further comprising a signal processing unit that performs at least one of exposure processing, focus adjustment processing, or white balance adjustment processing on a taken image corrected in the correction unit.

9. The electronic apparatus according to claim 2, further comprising:
a signal processing unit that performs at least one type of signal processing on a taken image corrected in the correction unit; and
a parameter adjustment unit that adjusts a parameter for when performing signal processing on the taken image according to a correction amount by which the correction unit corrects the taken image.

10. The electronic apparatus according to claim 9,
wherein signal processing performed by the signal processing unit includes at least either noise reduction processing that removes a noise component included in the taken image, or edge enhancement processing that enhances an edge in the taken image, and
the parameter adjustment unit adjusts, according to the correction amount, a parameter for when performing at least either the noise reduction processing or the edge enhancement processing.

11. The electronic apparatus according to claim 10, wherein the parameter adjustment unit performs, for a taken image having a larger correction amount, at least either processing of further increasing a degree of noise removal in the noise reduction processing, or processing of further increasing a degree of edge enhancement in the edge enhancement processing.

12. The electronic apparatus according to claim 9, wherein the signal processing unit performs signal processing including exposure adjustment processing, and, when performing the exposure adjustment processing, performs exposure adjustment so that output values of the plurality of photoelectric conversion units do not saturate.

13. The electronic apparatus according to claim 1, further comprising a defect correction unit that corrects, by using output values of surrounding two or more of the photoelectric conversion units, an output value of the photoelectric conversion unit on which light polarized by the polarizing element is incident.

14. The electronic apparatus according to claim 1, further comprising an imaging device having the photoelectric conversion unit and an optical system that condenses light on the photoelectric conversion unit,
wherein the imaging device is disposed on a side opposite to a vicinity of a substantially central portion of a display surface of the display unit.

15. The electronic apparatus according to claim 1, further comprising a defect correction unit that corrects an output value of a photoelectric conversion unit of which output value saturates, for a photoelectric conversion unit of which output value saturates among the plurality of photoelectric conversion units, on a basis of polarization information that is polarized in one or more of the polarizing elements disposed around the photoelectric conversion unit, and is photoelectrically converted in the photoelectric conversion unit.

16. The electronic apparatus according to claim 1,
wherein the photoelectric conversion unit has a plurality of divided photoelectric conversion units, and
light polarized by the plurality of polarizing elements is incident on the plurality of divided photoelectric conversion units in some of the photoelectric conversion units.

17. The electronic apparatus according to claim 1,
wherein the photoelectric conversion unit has a plurality of divided photoelectric conversion units, and
light polarized by the polarizing element is incident on some of the divided photoelectric conversion units in any of the photoelectric conversion units.

18. The electronic apparatus according to claim 1,
wherein the photoelectric conversion unit has a plurality of divided photoelectric conversion units, and
light polarized by the polarizing element is incident on the divided photoelectric conversion unit for each unit of two or more of the photoelectric conversion units.

19. The electronic apparatus according to claim 1,
wherein the plurality of photoelectric conversion units has a plurality of divided photoelectric conversion units, and
light polarized by the plurality of polarizing elements is incident on the plurality of photoelectric conversion units.

20. The electronic apparatus according to claim 1,
wherein the photoelectric conversion unit has a plurality of divided photoelectric conversion units divided into two or more in one direction and capable of detecting phase difference information, and
light polarized by the polarizing element is incident on the plurality of divided photoelectric conversion units in any of the photoelectric conversion units.
